# EUROPÄISCHE PATENTSCHRIFT

(11) **EP 0 999 670 B1**
(45) Veröffentlichungstag und Bekanntmachung des Hinweises auf die Patenterteilung: **22.01.2003**
(21) Anmeldenummer: 99120441.3
(22) Anmeldetag: 14.10.1999
(51) Int. Cl.: H04L 1/20, H03L 7/07

(54) **Verfahren und Vorrichtung zur Messung der Signalgüte eines digitalen Nachrichtenübertragungssystems**
Method and device for measuring the signal quality of a digital information transmission system
Procédé et dispositif pour mesurer la qualité de signal d'un système de transmission d'informations numériques

(30) Priorität: 02.11.1998 DE 19850567
(43) Veröffentlichungstag der Anmeldung: 10.05.2000
(73) Patentinhaber: Acterna Eningen GmbH, 72800 Eningen (DE)
(72) Erfinder: Bach, Roland, 72667 Schlaitdorf (DE); Dollinger, Helmut, 72658 Bempflingen (DE); Hoyer, Wolfgang, 72793 Pfullingen (DE)
(74) Vertreter: Klocke, Peter, Dipl.-Ing.

(56) Entgegenhaltungen:
- US-A- 5 585 954
- US-A- 5 757 857
- PATENT ABSTRACTS OF JAPAN vol. 1996, no. 11, 29. November 1996 (1996-11-29) & JP 08 195674 A (NEC CORP), 30. Juli 1996 (1996-07-30)

## Beschreibung

Die vorliegende Erfindung betrifft ein Verfahren und eine Vorrichtung zur Messung der Signalgüte eines digitalen Nachrichtenübertragungssystems unter Verwendung einer Abtasteinrichtung mit einstellbarer Gleichspannungsschwelle zur Ermittlung eines Signalparameters für die Signalgüte (Q-Faktor).

Zur Abschätzung der Bit-Fehlerrate (BER) eines digitalen Nachrichtenübertragungssystems wird die sogenannte Q-Faktor-Meßmethode angewandt, die zusätzlich Aussagen über das Signal zum Rauschverhältnis (S/N) eines Signals, das sogenannte Augenmuster und die Systemreserve liefert. Ausführliche Erläuterungen zu der Meßung des Q-Faktors finden sich in der Schrift der Firma Hewlett-Packard, "Measurement in High-Speed Optically Amplified Networks" aus den Seminarunterlagen von 1996 Lightwave Transmission Seminar", das im Mai 1996 in Böblingen bei der Firma HP statt fand und beispielsweise in der Druckschrift der ITU (International Telecommunication Union), Study-Period 1997 bis 2000, COM 15-31-E, November 1997, Question 16/15, Study Group 15 - Contribution 31.

Für elektrische digitale Nachrichtenübertragungssysteme wurde bisher eine Bit-Fehlerrate BER<=10⁻⁹ als ausreichend erachtet. Bei optischen digitalen Nachrichtenübertragungssystemen wird jedoch eine Bit-Fehlerrate BER von <=10⁻¹² für erforderlich angesehen. Um eine Messung auch bei optischen digitalen Übertragungssystemen mit den üblicherweise bei elektrischen digitalen Nachrichtenübertragungssystemen verwendeten Methoden durchzuführen, ist die Meßzeit zu lange.

Im Hinblick darauf, daß es in Zukunft sogenannte transparente optische Netze geben wird, bei denen die Datensignale nicht bekannt sind und daher die Netzbetreiber die Qualität des Systems bei unbekannten Signalen gewährleisten müssen, besteht ein Bedarf, nach einem Verfahren und einer Vorrichtung zur Bestimmung der Übertragungsqualität. Bis jetzt bekannte Geräte zur Ermittlung der Übertragungsqualität von digitalen Nachrichtenübertragungssystemen benötigen ein bekanntes Bit-Muster oder zusätzlich ein zweites Gerät zur Erzeugung eines Taktsignals. Während das erstgenannte Gerät ebenfalls eine rein numerische Ausgabe der Bit-Fehlerrate vorsieht, findet bei dem zweiten Gerät eine oszillographische Auswertung eines auch unbekannten Bit-Musters statt.

Allgemein sind Schaltungen bekannt, die auf ein unbekanntes Eingangssignal synchronisieren. Ein Beispiel dafür ist die US-A-5 757 857, die eine Schaltung offenbart, bei der über die Frequenzdifferenz zwischen Eingangssignal und Taktsignal auf das Datensignal synchronisiert wird.

Der vorliegenden Erfindung liegt daher die Aufgabe zugrunde, eine Möglichkeit vorzuschlagen, mit der die Qualität eines digitalen Nachrichtenübertragungssystems bei unbekannten Signalen innerhalb weniger Sekunden ermittelt und angegeben werden kann.

Diese Aufgabe wird erfindungsgemäß durch ein Verfahren mit den Merkmalen des Anspruchs 1 sowie durch eine Vorrichtung mit den Merkmalen des Anspruchs 3 gelöst. Weitere vorteilhafte Ausgestaltungen sind den jeweiligen diesbezüglich rückbezogenen Unteransprüchen zu entnehmen.

Gemäß dem Verfahren wird aus einem unbekannten Eingangssignal die Bit-Rate ermittelt und mittels dieser ein Taktsignal erzeugt, mit dem das Eingangssignal über die Abtasteinrichtung abgetastet wird. Bei dem unbekannten Eingangssignal handelt es sich um ein elektrisches Eingangssignal, das entweder aus einem elektrischen digitalen Nachrichtenübertragungssystem oder durch Umwandlung aus einem optischen digitalen Nachrichtenübertragungssystem gewonnen wird. Aus diesem wird die Häufigkeit der Bits pro Zeit ermittelt und das Taktsignal erzeugt. Der Abtasteinrichtung, über die das Eingangssignal abgetastet wird, liegt die bekannte, eingangs diskutierte Methode der Ermittlung der Bitfehler-Rate BER mittels zweier Entscheider als Funktion der Abtastschwelle zugrunde.

Gemäß einer bevorzugten Ausbildung des Verfahrens wird mittels einer frequenzempfindlichen Synchronisierschaltung der Taktgenerator auf die Datenfrequenz synchronisiert. Dies kann beispielsweise mittels eines Suchoszillators oder durch die Ermittlung der Bit-Rate aus der Anzahl pro Zeit der positiven oder negativen Flanken des Eingangssignals erfolgen. Letzterem liegt der Gedanke zugrunde, daß bei einem Viertel aller zusammenhängenden Bit-Blöcke die Flanken, bezogen auf die Taktrate, positiv sind (vgl. hierzu FREQUENZ 1970/8, Seite 230 bis 234 -insbesondere Tabelle 1-, "Eigenschaften und Anwendung von binären Quasi-Zufallsfolgen" von Lutz Schweizer). Aufgrund dieser Erkenntnis kann aus der Häufigkeit der positiven oder negativen Flanken durch die Multiplikation mit 4 auf die Bit-Rate geschlossen und aus dieser ein entsprechendes Taktsignal erzeugt werden.

Für die Abtastung des Eingangssignals über die Abtasteinrichtung wird zur genauen Synchronisation gemäß einer weiteren vorteilhaften Ausbildung des Verfahrens mittels der Bit-Rate, die dem Taktsignal entspricht, ein Abtastoszillator voreingestellt und anschließend dieser durch Phasenvergleich zum Eingangssignal synchronisiert. Dies dient der Feinjustase, wobei derart justiert wird, daß in Bildmitte, d. h. in der Mitte des digitalen Impulses, abgetastet werden kann.

Bei der ausgestalteten Vorrichtung ermittelt ein Flankenzähler aus dem unbekannten Eingangssignal die Bit-Rate. Mit dem Flankenzähler ist ein Taktgenerator verbunden, der von diesem ein Voreinstellungssignal erhält und der über eine Phasenregelschleife mit der Abtasteinrichtung durch Phasenvergleich mit dem Eingangssignal auf dieses synchronisiert.

Das Verfahren sowie die Vorrichtung gestatten somit das Monitoren von elektrischen und optischen digitalen Nachrichtenübertragungssystemen bei unbekannter Bit-Rate. Dabei wird die Bit-Rate numerisch angegeben. Außerdem ist eine Aussage über die Größe des Q-Faktors und alle daraus abgeleiteten Größen möglich. Es wird eine Meßmethode vorgeschlagen (Q-Faktor) die Bitfehlerrate alternativ zu messen, mit der die Meßzeit wesentlich verkürzt werden kann. Das bekannte Eingangssignal wird dabei mit zwei Abtastern simultan abgetastet, wobei der erste (Referenzabtaster) bei optimaler Abtastschwelle abtastet und den Takt aus dem Eingangssignal zurückgewinnt, und der zweite (Meßabtaster) mit variabler Abtastschwelle abtastet. Mit einem EXOR wird der Unterschied beider Abtasterausgänge (=Bitfehler) in Abhängigkeit der Meßabtaster Abtastschwelle detektiert. Dieses Prinzip setzt keine Kenntnis des Signals voraus und kann am aktiven Nachrichtenübertragungssystem angewandt werden.

Das Verfahren sowie die Vorrichtung basieren darauf, daß, wie insbesondere bei optischen Übertragungssystemen üblich, ein sogenanntes NRZ-Signal als Übertragungssignal vorliegt, bei dem der Signalpegel "HOCH" einer digitalen "1" und der Signalpegel "TIEF" einer digitalen "0" entspricht.

In Verbindung mit den Figuren wird nachfolgend die Erfindung anhand eines Ausführungsbeispiels näher erläutert. Es stellen dar
- Figur 1: Ein allgemeines Blockschaltbild einer Meßvorrichtung und
- Figur 2: ein detaillierteres Blockschaltbild einer Meßvorrichtung nach Figur 1.

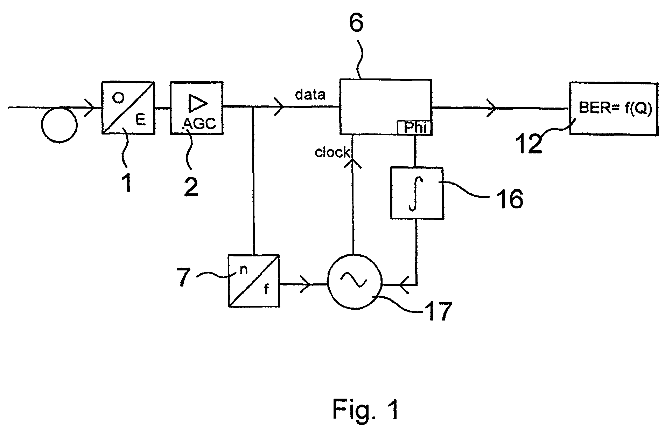

Figur 1 zeigt schematisch die Ermittlung der Signalgüte eines optischen Nachrichtenübertragungssystems. Das optische Signal wird über einen optischen Wandler 1 und einem Verstärker 2 einer bekannten Abtasteinrichtung 6 sowie einem Flankenzähler 7 zugeführt. Anstelle des Flankenzählers 7 kann auch ein Suchoszillator verwendet werden, der eine Information über die Differenz von Daten- und Taktsignal liefert. Der Flankenzähler 7 (bzw. der Suchoszillator) ermittelt die Bit-Rate und liefert ein Voreinstellungssignal an einen spannungsgesteuerten Oszillator 17, der ein Taktsignal abgibt. Über eine Phasenregelschleife (PLL) 16 und Phasenvergleich mit dem Eingangssignal an der Abtasteinrichtung 6 wird diese auf das Eingangssignal synchronisiert. Die Abtasteinrichtung 6 gibt über die Einrichtung 12 die Bit-Fehlerrate BER als Funktion von Q ab.

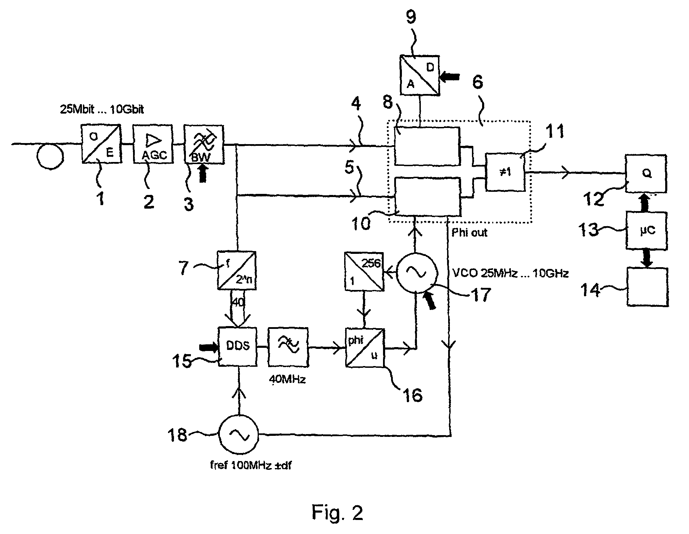

In Figur 2 ist die schematische Darstellung von Figur 1 detaillierter dargestellt.

In dem Ausführungsbeispiel wird von einem unbekannten optischen Eingangssignal mit beispielsweise 25 Mbit bis 10Gbit ausgegangen, das über einen entsprechenden optischen Wandler 1 in ein elektrisches Signal umgewandelt wird. Diese Einrichtung erübrigt sich bei der Ermittlung des Q-Faktors eines elektrischen Signals. Das elektrische Signal wird im Anschluß daran in bekannter Weise über einen Verstärker 2 und einen Tiefpaß 3 geleitet und im Anschluß daran den beiden Kanälen 4 und 5 einer Abtasteinrichtung 6 sowie einem Flankenzähler 7 zugeführt. Der Meßkanal 4 der Abtasteinrichtung 6 führt auf einen Meßentscheider 8, der mit einem Analog/Digital-Wandler 9 verbunden ist, über den die Entscheiderschwelle verschoben werden kann. Der Referenzkanal 5 führt zu einem Referenzentscheider 10 und die beiden Ausgänge der Entscheider werden über ein EXOR-Glied 11 einem Bit-Fehlerraten-Zähler 12 zugeführt. Mittels eines Mikroprozessors 13 wird nach bekannter Methode aus den gemessenen Bitfehlern der Q-Faktor berechnet und in einer Anzeigeeinrichtung 14 dargestellt.

Zur Synchronisation des Referenzentscheiders 10 in der Abtastvorrichtung 6 wird die in dem Flankenzähler 7 ermittelte Bit-Rate einem direkten digitalen Synthesizer 15 zugeführt und mittels einer phasengeregelten Schleife (PLL) 16 über einen spannungsgesteuerten Oszillator (VCO) 17 sowie einem Referenzoszillator 18 der Referenzentscheider 10 auf das Eingangssignal synchronisiert. Der spannungsgesteuerte Oszillator 17 arbeitet in einem Bereich von 25MHz bis 10GHz und der Referenzspannungsoszillator in einem Bereich von 100 MHz. Der Synthesizer 15 kann auch die Funktion des Flankenzählers 7 ersetzen, indem er als Suchoszillator verwendet wird. Dazu wird der Synthesizer 15 über einen weiten Bereich verstellt und die Informationen aus der Differenzfrequenz des Daten- und des Taktsignals werden ausgewertet und zur Voreinstellung des Oszillators 17 verwendet.

Der spannungsgesteuerte Oszillator 17 stellt sich automatisch auf die Bit-Rate des gemessenen Signals ein. Dazu werden die positiven oder negativen Flanken des Eingangssignals innerhalb einer bestimmten Torzeit in dem Flankenzähler 7 gemessen. Bei quasi zufälligen NRZ (Non Return to Zero) Signalen ist ein Viertel aller Flanken positiv oder negativ, so daß die Bit-Rate direkt aus der Flankenzahl ermittelt werden kann. Der Mikroprozessor 13 stellt den direkten digitalen Synthesizer (DDS) 15 so ein, daß die Ausgangsfrequenz des Taktgenerators 17 ungefähr der Bit-Rate entspricht. Die phasengeregelte Schleife 16 verstimmt im Zusammenwirken mit dem Phasenmesserausgang des EXOR-Gliedes 11 die Ausgangsfrequenz des direkten digitalen Synthesizers 15 nach dem Schließen des Regelkreises so, daß die Bit-Rate mit der Abtastfrequenz übereinstimmt. Die zwei Entscheider 8, 10 in der Abtasteinrichtung 6 werden zur Messung an den aktiven Übertragungssystemen benutzt. Der Meßentscheider 8 wird in seiner Entscheiderschwelle mittels eines Analog/Digital-Wandler 9 verschoben. Der Ausgang der beiden Entscheider 8, 10 wird dem EXOR-Glied zugeführt und in dem nachgeschalteten Bit-Fehlerraten-Zähler 12 gemessen.

## Patentansprüche

1. Verfahren zur Ermittlung der Signalgüte eines sich im Betrieb befindlichen optischen, digitalen Nachrichtenübertragungssystems mit den folgenden Schritten:
• Ermittlung der Bit-Rate des zu untersuchenden unbekannten Eingangssignals,
• Einstellung einer Taktrückgewinnungseinrichtung auf die ermittelte Bit-Rate
• Abgleich der gewünschten Phasenposition innerhalb eines Bits durch Phasenvergleich mit dem Eingangssignal,
• Zählen von Bit-Fehlern durch Vergleich des Ausgangssignals zweier Signalabtasteinrichtungen, wobei eine Abtasteinrichtung mit einer vorgegebenen Referenz-Abtastschwelle und die andere Abtasteinrichtung mit einer veränderlichen Abtastschwelle betrieben wird,
• Berechnung der Signalgüteparameter Q-Faktor und Bit-Fehlerrate aus den gemessenen Bit-Fehlern und
• Ausgabe der Bit-Rate, des Q-Faktors und der Bit-Fehlerrate.

2. Verfahren nach Anspruch 1, **dadurch gekennzeichnet, dass** die Ermittlung der Bit-Rate durch Detektion der Flanken des unbekannten Signals unter Berücksichtigung des Signaltyps durchgeführt wird.

3. Vorrichtung zur Ermittlung von Signalparameter für die Signalgüte eines optischen digitalen Nachrichtenübertragungssystems mit einer Abtasteinrichtung (6) mit einstellbarer Gleichspannungsschwelle, **gekennzeichnet durch,**
• eine Detektionseinrichtung (7, 15), die aus dem unbekannten Eingangssignal die Bit-Rate ermittelt,
• einen Taktgenerator (17), der mit der Detektionseinrichtung (7, 15) verbunden ist und von dieser ein Voreinstellungssignal erhält und der über eine Phasenregelschleife (16) mit einer Abtasteinrichtung (6) **durch** Phasenvergleich mit dem Eingangssignal auf dieses synchronisiert.

## Claims

1. Method of determining the signal quality of an optical, digital communications system, in operation, said method having the following steps:
• determining the bit rate of the unknown input signal to be investigated,
• setting a timing recovery means to the determined bit rate,
• balancing the desired phase position within one bit by a phase comparison with the input signal,
• counting bit errors by comparing the output signals of two signal scanning means, one scanning means being operated with a prescribed reference scanning threshold, and the other scanning means being operated with a variable scanning threshold,
• calculating the signal quality parameters, the Q factor and the bit error rate, from the measured bit errors, and
• reading-out the bit rate, the Q factor and the bit error rate.

2. Method according to claim 1, **characterised in that** the bit rate is determined by detecting the edges of the unknown signal, taking account of the signal type.

3. Apparatus for determining signal parameters for the signal quality of an optical, digital communications system, using a scanning means (6) having an adjustable d.c. voltage threshold, **characterised by**:
• a detector (7, 15) which determines the bit rate from the unknown input signal, and
• a clock generator (17), which is connected to the detector (7, 15) and receives from said detector a preadjustment signal, and said generator is synchronised with the input signal via a phase locked loop (16) with a scanning means (6) by a phase comparison with said input signal.

## Revendications

1. Procédé pour mesurer la qualité de signal d'un système de transmission d'informations optiques numériques en fonctionnement, au moyen des étapes suivantes :
• détermination de la vitesse en bauds du signal d'entrée inconnu à analyser,
• réglage d'un dispositif de récupération d'horloge sur la vitesse en bauds déterminée,
• alignement de la position de phase souhaitée au sein d'un bit avec le signal d'entrée par comparaison de phase,
• comptage des erreurs sur les bits par comparaison du signal de sortie de deux dispositifs d'échantillonnage de signaux, l'un des dispositifs d'échantillonnage fonctionnant avec un seuil d'échantillonnage de référence prédéfini et l'autre dispositif d'échantillonnage avec un seuil d'échantillonnage variable,
• calcul des paramètres de qualité de signal, du facteur Q et du taux d'erreurs Sur les bits à partir des erreurs sur les bits mesurées et
• sortie du débit binaire, du facteur Q et du taux d'erreurs sur les bits.

2. Procédé selon la revendication 1, **caractérisé par le fait que** la détermination du débit binaire est réalisée par détection des flancs du signal inconnu en tenant compte du type de signal.

3. Dispositif pour déterminer les paramètres de la qualité de signal d'un système de transmission d'informations optiques numériques comportant un dispositif d'échantillonnage (6) à seuil de tension continue réglable, **caractérisé par**
• un dispositif de détection (7, 15) qui détermine le débit binaire du signal d'entrée inconnu,
• un générateur d'horloge (17) qui est relié au dispositif de détection (7, 15) et reçoit de celui-ci un signal de préréglage et qui, au moyen d'une boucle à verrouillage de phase (16) et d'un dispositif d'échantillonnage (6), se synchronise sur le signal d'entrée par comparaison de phase avec lui.
